# EUROPEAN PATENT APPLICATION

(11) **EP 3 683 833 A1**
(43) Date of publication of application: **22.07.2020**
(21) Application number: 18917583.9
(22) Date of filing: 30.08.2018
(51) Int. Cl.: H01L 27/112, G11C 17/14

(54) **STORAGE UNIT, STORAGE DEVICE, AND METHOD FOR OPERATING STORAGE UNIT**

(71) Applicant: Shenzhen Weitongbo Technology Co., Ltd., Shenzhen, Guangdong 518052 (CN)
(72) Inventor: WANG, Wenxuan, Shenzhen, Guangdong 518052 (CN); SHEN, Jian, Shenzhen, Guangdong 518052 (CN); LI, Yunning, Shenzhen, Guangdong 518052 (CN)
(74) Representative: J A Kemp LLP
(86) International application number: PCT/CN2018/103223
(87) International publication number: WO 2020/042078

(57) **Abstract**

The present invention provides a memory cell, a memory device and an operation method of a memory cell. The memory cell includes: an anti-fuse transistor including a gate, a source and a drain, the anti-fuse transistor being formed by a Metal-Oxide-Semiconductor Field-Effect Transistor; and a gate tube, electrically connected to the gate of the anti-fuse transistor, where the gate and the source respectively forming two ends of a first anti-fuse capacitor, and the gate and the drain respectively form two ends of a second anti-fuse capacitor. Thus the area of the anti-fuse structure can be reduced, and the memory capacity of the memory cell can be improved.

## Description

### TECHNICAL FIELD

The present application relates to the field of semiconductor technologies and, in particular, relates to a memory cell, a memory device, and an operation method of a memory cell.

### BACKGROUND

A programmable read-only memory, also known as a one time programmable memory, refers to a read-only memory that is allowed to be written only once. The commonly used structure of the one time programmable memory includes: a fuse structure, an anti-fuse structure, a floating gate structure, and so on. The structure of one time programmable memory structure of the anti-fuse structure is superior to the one time programmable memory of the fuse structure and the floating gate structure in safety and reliability.

At present, a structure of one time programmable memory structure of the anti-fuse structure generally includes at least one control tube and one anti-fuse capacitor. In an integrated circuit, one control tube can also be integrated with one capacitor to form an integral structure, so as to form one memory cell of the one-time programmable memory.

However, for the existing one time programmable memory of the anti-fuse structure, it is still needed in principle to generate gate oxide layers of two thicknesses through a dual gate process, and then to constitute one memory cell by one control tube and one anti-fuse capacitor together. The one time programmable memory of such anti-fuse structure is limited by the area of the anti-fuse structure, and the memory capacity is not high.

### SUMMARY

The present invention provides a memory cell, a memory device, and an operation method of a memory cell to increase the memory capacity of a one time programmable memory of an anti-fuse structure.

In a first aspect, an embodiment of the present invention provides a memory cell, including:
an anti-fuse transistor, including a gate, a source and a drain, the anti-fuse transistor being formed by a Metal-Oxide-Semiconductor Field-Effect Transistor (MOSFET); and
a gate tube, electrically connected to the gate of the anti-fuse transistor, where the gate and the source respectively form two ends of a first anti-fuse capacitor, and the gate and the drain respectively form two ends of a second anti-fuse capacitor.

Optionally, the two ends of the first anti-fuse capacitor are respectively connected to a power end of an external circuit;
where a voltage is applied to the two ends of the first anti-fuse transistor through the power end of the external circuit to partially break down an oxide dielectric layer between the gate and the source of the anti-fuse transistor, so that the gate and the source of the anti-fuse transistor form a conductive path to complete programming for the first anti-fuse capacitor.

Optionally, the two ends of the second anti-fuse capacitor are respectively connected to a power end of an external circuit;
where under an external voltage, an oxide dielectric layer between the gate and the drain of the anti-fuse transistor is partially broken down, so that the gate and the drain of the anti-fuse transistor form a conductive path to complete programming for the second anti-fuse capacitor.

Optionally, the gate tube includes a Metal-Oxide-Semiconductor Field-Effect Transistor (MOSFET).

In a second aspect, an embodiment of the present invention provides an operation method of a memory cell, which is applied to the memory cell according to any one of the first aspect, where the method includes:
forming a first voltage difference between the gate and the source of the anti-fuse transistor or forming a second voltage difference between the gate and the drain of the anti-fuse transistor, by controlling magnitude of a gate voltage, a source voltage, a drain voltage and a base voltage of the anti-fuse transistor;
if the first voltage difference is greater than a breakdown voltage of an oxide dielectric layer between the gate and the source of the anti-fuse transistor, completing a programming operation for the first anti-fuse capacitor formed by the gate and the source of the anti-fuse transistor; and
if the second voltage difference is greater than a breakdown voltage of an oxide dielectric layer between the gate and the drain of the anti-fuse transistor, completing programming for the second anti-fuse capacitor formed by the gate and the drain of the anti-fuse transistor.

Optionally, when the anti-fuse transistor is a P-type MOSFET, the forming a first voltage difference between the gate and the source of the anti-fuse transistor by controlling magnitude of a gate voltage, a source voltage, a drain voltage and a base voltage of the anti-fuse transistor includes:
controlling the gate voltage, the drain voltage and the base voltage of the anti-fuse transistor to be a high voltage, and controlling the source voltage of the anti-fuse transistor to be a low voltage or a zero voltage, to form the first voltage difference between the gate and the source of the anti-fuse transistor.

Optionally, when the anti-fuse transistor is a P-type MOSFET, the forming a second voltage difference between the gate and the drain of the anti-fuse transistor by controlling magnitude of a gate voltage, a source voltage, a drain voltage and a base voltage of the anti-fuse transistor includes:
controlling the gate voltage, the source voltage and the base voltage of the anti-fuse transistor to be a high voltage, and controlling the drain voltage of the anti-fuse transistor to be a low voltage or a zero voltage, to form the second voltage difference between the gate and the source of the anti-fuse transistor.

Optionally, when the anti-fuse transistor is an N-type MOSFET, the forming a first voltage difference between the gate and the source of the anti-fuse transistor by controlling magnitude of a gate voltage, a source voltage, a drain voltage and a base voltage of the anti-fuse transistor includes:
controlling the gate voltage, the drain voltage and the base voltage of the anti-fuse transistor to be a high voltage, and controlling the source voltage of the anti-fuse transistor to be a low voltage or a zero voltage, to form the first voltage difference between the gate and the source of the anti-fuse transistor.

Optionally, when the anti-fuse transistor is an N-type MOSFET, the forming a second voltage difference between the gate and the drain of the anti-fuse transistor by controlling magnitude of a gate voltage, a source voltage, a drain voltage and a base voltage of the anti-fuse transistor includes:
controlling the gate voltage, the source voltage and the base voltage of the anti-fuse transistor to be a low voltage, and controlling the drain voltage of the anti-fuse transistor to be a high voltage or a zero voltage, to form the second voltage difference between the gate and the source of the anti-fuse transistor.

In a third aspect, an embodiment of the present invention provides an operation method of a memory cell, which is applied to the memory cell according to any one of the first aspect, where the method includes:
applying a gate voltage to the gate of the anti-fuse transistor through the gate tube, so that the anti-fuse transistor is in an On state; applying a source voltage, a drain voltage, a base voltage to the source, the drain and a base of the anti-fuse transistor, respectively; and
acquiring an electrical signal of the source or the drain of the anti-fuse transistor; where the electrical signal of the source of the anti-fuse transistor corresponds to a programming result for the first anti-fuse capacitor; and the electrical signal of the drain of the anti-fuse transistor corresponds to a programming result for the second anti-fuse capacitor.

Optionally, when the anti-fuse transistor is a P-type MOSFET, the acquiring an electrical signal of the source of the anti-fuse transistor includes:
controlling the gate voltage of the anti-fuse transistor to be a high voltage, the source voltage and the base voltage of the anti-fuse transistor to be a zero voltage or a same low voltage, and not applying a voltage to the drain of the anti-fuse transistor; acquiring a voltage or current signal at the source of the anti-fuse transistor; where a voltage difference between the gate and the source of the anti-fuse transistor is much smaller than the oxide layer dielectric breakdown voltage of the anti-fuse transistor;
when the anti-fuse transistor is the P-type MOSFET, the acquiring an electrical signal of the drain of the anti-fuse transistor includes:
   controlling the gate voltage of the anti-fuse transistor to be a high voltage, the drain voltage and the base voltage of the anti-fuse transistor to be a zero voltage or a same low voltage, and not applying a voltage to the source of the anti-fuse transistor; acquiring a voltage or current signal at the drain of the anti-fuse transistor; where a voltage difference between the gate and the drain of the anti-fuse transistor is much smaller than the oxide layer dielectric breakdown voltage of the anti-fuse transistor.

Optionally, when the anti-fuse transistor is an N-type MOSFET, the acquiring an electrical signal of the source of the anti-fuse transistor includes:
controlling the gate voltage of the anti-fuse transistor to be a high voltage, the source voltage and the base voltage of the anti-fuse transistor to be a zero voltage or a same low voltage, and not applying a voltage to the drain of the anti-fuse transistor; acquiring a voltage or current signal at the source of the anti-fuse transistor; acquiring a voltage or current signal at the source of the anti-fuse transistor; where a voltage difference between the gate and the source of the anti-fuse transistor is much smaller than the oxide layer dielectric breakdown voltage of the anti-fuse transistor;
when the anti-fuse transistor is the N-type MOSFET, the acquiring an electrical signal of the drain of the anti-fuse transistor includes:
   controlling the gate voltage of the anti-fuse transistor to be a high voltage, the drain voltage and the base voltage of the anti-fuse transistor to be a zero voltage or a same low voltage, and not applying a voltage to the source of the anti-fuse transistor; acquiring a voltage or current signal at the drain of the anti-fuse transistor; where a voltage difference between the gate and the drain of the anti-fuse transistor is much smaller than the oxide layer dielectric breakdown voltage of the anti-fuse transistor.

In a fourth aspect, an embodiment of the present invention provides a memory device, including: at least one memory cell according to any one of the first aspect, a control signal input circuit; where the control signal input circuit is configured to generate a gate voltage, a source voltage, a drain voltage and a base voltage of the anti-fuse transistor, to execute the operation method of a memory cell according to any one of claims 5 to 9 on the memory cell.

Optionally, the memory device further includes: a memory cell reading circuit, where the memory cell reading circuit is configured to execute the operation method of a memory cell according to any one of the third aspect.

In a fifth aspect, an embodiment of the present invention provides a programming device for a memory cell, including:
a memory, configured to store a program; and
a processor, configured to execute the program stored in the memory, where when the program is executed, the processor is configured to program the memory cell according to any one of the first aspect using the operation method of a memory cell according to any one of the second aspect.

In a sixth aspect, an embodiment of the present invention provides a reading device for a memory cell, including:
a memory, configured to store a program; and
a processor, configured to execute the program stored in the memory, where when the program is executed, the processor is configured to read a programming result for the memory cell according to any one of the first aspect using the operation method of a memory cell according to any one of the third aspect.

In a seventh aspect, an embodiment of the present invention provides a computer readable storage medium, including: instructions, which when executed on a computer, cause the computer to execute the operation method of a memory cell according to any one of the second aspect to program the memory cell according to any one of the first aspect.

In an eighth aspect, an embodiment of the present invention provides a computer readable memory medium, including: instructions, which when executed on a computer, cause the computer to execute the operation method of a memory cell according to any one of the third aspect to read a programming result for the memory cell according to any one of the first aspect.

Using the memory cell, the memory and the operation method of a memory cell provided by the present invention, a memory cell is constructed by a gate tube and an anti-fuse transistor, the anti-fuse transistor being formed by a Metal-Oxide-Semiconductor Field-Effect Transistor (MOSFET); the gate tube is electrically connected to the gate of the anti-fuse transistor; where the gate and the source of the anti-fuse transistor respectively form two ends of a first anti-fuse capacitor, and the gate and the drain of the anti-fuse transistor respectively form two ends of a second anti-fuse capacitor. Thus the area of the anti-fuse structure can be reduced, and the memory capacity of the memory cell can be improved.

### BRIEF DESCRIPTION OF THE DRAWINGS

In order to more clearly illustrate technical solutions in embodiments of the present invention or in the prior art, the drawings used in describing the embodiments or the prior art will be briefly described below. Obviously, the drawings in the following description are some embodiments of the present invention, and those skilled in the art could obtain other drawings from these drawings without creative effort.
FIG. 1 is a schematic structural diagram of two anti-fuse capacitors formed by a P-type MOSFET according to Embodiment 1 of the present invention;
FIG. 2 is a schematic diagram of an equivalent circuit of two anti-fuse capacitors formed by a P-type MOSFET according to Embodiment 2 of the present invention;
FIG. 3 is a schematic diagram of an equivalent circuit of a P-type MOSFET after being programmed according to Embodiment 3 of the present invention;
FIG. 4 is a schematic structural diagram of a memory cell according to Embodiment 4 of the present invention;
FIG. 5 is a flowchart of an operation method of a memory cell according to Embodiment 5 of the present invention;
FIG. 6 is a flowchart of an operation method of a memory cell according to Embodiment 6 of the present invention;
FIG. 7 is a schematic structural diagram of a memory device according to Embodiment 7 of the present invention;
FIG. 8 is a schematic structural diagram of a memory device according to Embodiment 8 of the present invention;
FIG. 9 is a schematic structural diagram of a programming device for a memory cell according to Embodiment 9 of the present invention; and
FIG. 10 is a schematic structural diagram of a reading device for a memory cell according to Embodiment 10 of the present invention.

The embodiments of the present disclosure have been shown by the accompanying drawings described above, and will be described in more detail later. The drawings and text descriptions are not intended to limit the scope of the concept of the present disclosure in any way, but to illustrate the concept of the present disclosure for those skilled in the art by reference to specific embodiments.

### DETAILED DESCRIPTION OF THE EMBODIMENTS

In order to make purposes, technical solutions and advantages of embodiments of the present invention clearer, technical solutions in the embodiments of the present invention will be clearly and completely described in conjunction with the drawings in the embodiments of the present invention. Obviously, the described embodiments are part of embodiments of the present invention, rather than all of the embodiments. All other embodiments obtained by those skilled in the art based on the embodiments of the present invention without creative effort are within the protection scope of the present invention.

The terms "first", "second", "third", "fourth", etc. (if present) in the specification, claims and the above drawings of the present invention are used to distinguish similar objects rather than to describe a specific sequence or order. It should be understood that the data used in this way may be interchanged in suitable situations, such that the embodiments of the present invention described herein can be implemented, for example, in a sequence other than those illustrated or described herein. In addition, the terms "comprise" and "have" and any variations of them are intended to cover a non-exclusive inclusion. For example, processes, methods, systems, products, or devices that contain a series of steps or units are not necessarily limited to those steps or units clearly listed, but may include other steps or units that are not clearly listed or inherent to such processes, methods, products or devices.

The technical solutions of the present invention will be described in detail below with specific embodiments. The following specific embodiments may be combined with each other, and the same or similar concepts or processes may be not repeated in some embodiments.

Hereinafter, some of the terms in the present application will be explained for easy understanding by those skilled in the art.
1) A programmable read-only memory (PROM) is allowed to be written only once, so it is also called "One Time Programmable ROM" (OTP-ROM). When the PROM is left the factory, the stored contents are all 1, and the user can write data 0 into some of the cells as needed (for part of the PROMs, data is all 0 when leaving the factory, then the user can write 1 into some of the cells) to achieve the purpose of programming.

The technical solutions of the present invention and how the technical solutions of the present application solve the above technical problems will be described in detail below with specific embodiments. The following specific embodiments may be combined with each other, and the same or similar concepts or processes may be not repeated in some embodiments. Embodiments of the present invention will be described below with reference to the accompanying drawings.

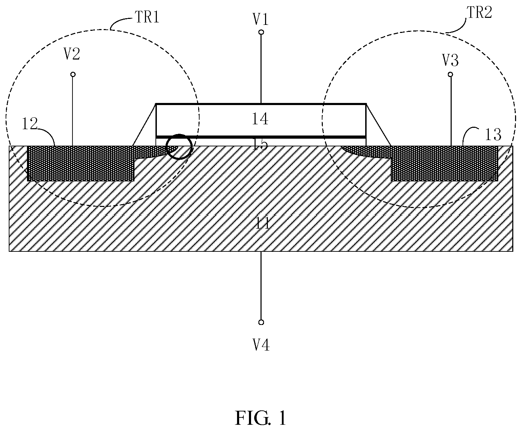

FIG. 1 is a schematic structural diagram of two anti-fuse capacitors formed by a P-type MOSFET according to Embodiment 1 of the present invention. As shown in FIG. 1, an N-type well doped region 11, a P-type source doped region 12, a P-type drain doped region 13, a gate region 14 made of polysilicon or metal or the like (in this embodiment, the material for making the gate is not limited), and an oxide dielectric layer 15 are included. The N-type doping element may be an element such as phosphorus; the P-type doping element may be an element such as boron; the oxide dielectric layer 15 may be an oxide layer insulating dielectric such as silicon dioxide, or may be a dielectric layer such as zirconia HfO2 (in this embodiment, the material for making the oxide dielectric layer is not limited).

When the P-type MOSFET operates as an anti-fuse capacitor, the gate, the source, the drain, and the base of the P-type MOSFET are respectively connected to an external circuit (the voltage applied to the gate, the source, the drain and the base of the P-type MOSFET by the external circuit are denoted as V1, V2, V3, and V4, respectively), a first anti-fuse capacitor is denoted as TR1, and a second anti-fuse capacitor is denoted as TR2. Specifically, V1 is controlled to be a high level, and if the breakdown of TR1 is to be achieved, V3 and V4 are controlled to be the same high level as V1, and V2 is controlled to be a low potential or a zero potential (the purpose is to generate a voltage difference, which could break down the oxide dielectric layer 15 between the gate and the source, at the gate of the P-type MOSFET). Since a breakdown voltage of the oxide dielectric layer 105 is much smaller than a breakdown voltage of a PN junction, after a certain period of voltage pulse action (or continuous voltage action), the first anti-fuse capacitor TR1 is partially broken down, so that the gate and source parts of the P-type MOSFET form a conductive path, thereby achieving a memory function of a cell. The programming principle of the second anti-fuse capacitor TR2 of the P-type MOSFET is similar to that of the first anti-fuse capacitor TR1. Specifically, V1 is controlled to be a high level, and if the breakdown of TR2 is to be achieved, V2 and V4 are controlled to be the same high level as V1, and V3 is controlled to be a low potential or a zero potential (the purpose is to generate a voltage difference, which could break down the oxide dielectric layer 15 between the gate and the drain, at the gate of the P-type MOSFET).

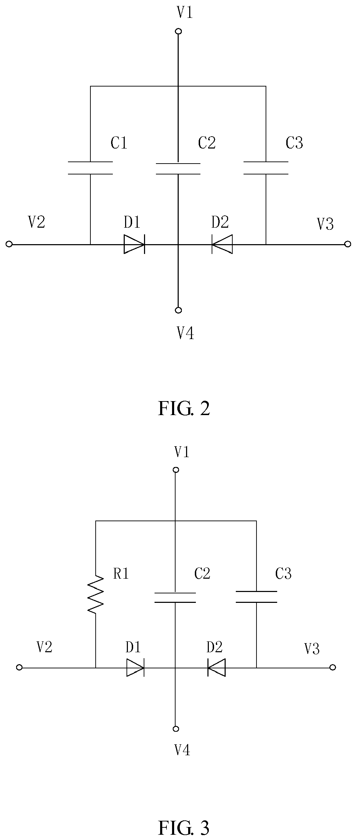

FIG. 2 is a schematic diagram of an equivalent circuit of two anti-fuse capacitors formed by a P-type MOSFET according to Embodiment 2 of the present invention. As shown in FIG. 2, a capacitor C1 and a capacitor C3 correspond to the capacitance formed by the source and the gate of the MOSFET, and the capacitance formed by the drain and the gate of the MOSFET, respectively, which are equivalent to the first anti-fuse capacitor TR1 and the second anti-fuse capacitor TR2, respectively. The capacitor C2 is the capacitance formed by the substrate and the gate of the MOSFET. A diode D1 and a diode D2 correspond to an equivalent PN junction diode formed by the source and the substrate of the MOSFET, and an equivalent PN junction diode formed by the drain and the substrate of the MOSFET, respectively.

Specifically, if the capacitor C1 is programmed, it is needed to apply the same high levels V1, V3, V4 (to ensure that the capacitor C2 and the capacitor C3 are not broken down) while applying a low level or a zero level V2. Under the premise that a reverse breakdown voltage of a PN junction is much greater than a breakdown voltage of a gate oxide layer, the capacitor C1 is broken down after a period of voltage action, while the diode D1 and the diode D2 stay intact and are not broken down. At this time, the equivalent circuit becomes the circuit shown in FIG. 3. FIG. 3 is a schematic diagram of an equivalent circuit of a P-type MOSFET after being programmed according to Embodiment 3 of the present invention. As shown in FIG. 3, the capacitor C1 is broken down to form an equivalent resistor R1, thus the programming for the capacitor C1 is completed.

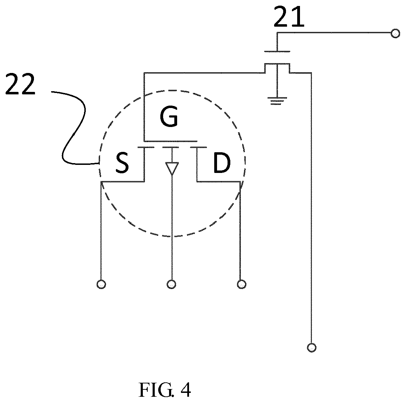

FIG. 4 is a schematic structural diagram of a memory cell according to Embodiment 4 of the present invention. As shown in FIG. 4, the memory cell in this embodiment includes: a gate tube 21, an anti-fuse transistor 22, the anti-fuse transistor being formed by a Metal-Oxide-Semiconductor Field-Effect Transistor (MOSFET); the gate tube 21 is electrically connected to the gate of the anti-fuse transistor; where the gate and the source of the anti-fuse transistor 22 respectively form two ends of a first anti-fuse capacitor, and the gate and the drain of the anti-fuse transistor respectively form two ends of a second anti-fuse capacitor.

In this embodiment, the anti-fuse transistor may be an N-type MOSFET or a P-type MOSFET. For the specific principle and implementation process for the P-type MOSFET, please refer to the description with reference to FIG. 1 to FIG. 3, which will not be repeated here. The specific principle and implementation process for the N-type MOSFET are similar to those for the P-type MOSFET, and the only difference lies in that the magnitude of the voltages V1, V2, V3, and V4 on the gate, the source, the drain, and the base of the N-type MOSFET is set different from those for the P-type MOSFET.

In an optional implementation, a voltage is applied to two ends of the first anti-fuse capacitor through a power end of an external circuit to partially break down an oxide dielectric layer between the gate and the source of the anti-fuse transistor, so that the gate and the source of the anti-fuse transistor form a conductive path to complete programming for the first anti-fuse capacitor. Optionally, the gate tube can be a Metal-Oxide-Semiconductor Field-Effect Transistor (MOSFET). It should be noted that this embodiment does not limit the specific type of the gate tube. Other switching devices may also be selected as the gate tube, and the function is to complete the selection of the anti-fuse transistor. Taking the gate tube being a MOSFET as an example, a voltage is applied to the gate of the gate tube to make the gate tube in an On state, and when a voltage is applied to the source/drain of the gate tube, the gate tube can apply a voltage to the gate of the anti-fuse transistor, so that the anti-fuse transistor is in an On state.

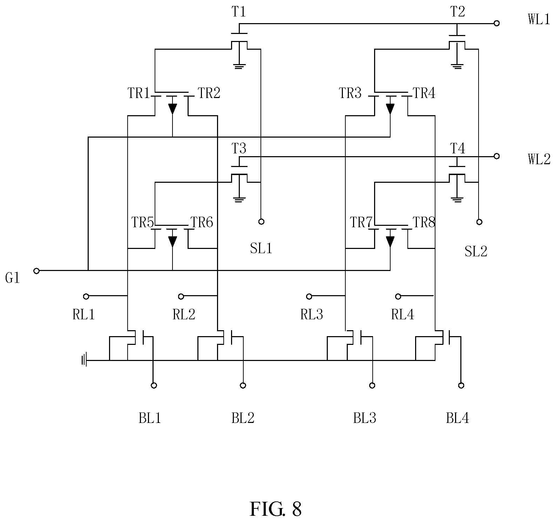

In another optional implementation, a voltage is applied to two ends of the second anti-fuse capacitor through the power end of the external circuit to partially break down an oxide dielectric layer between the gate and the drain of the anti-fuse transistor, so that the gate and the drain of the anti-fuse transistor form a conductive path to complete programming for the second anti-fuse capacitor. Optionally, the gate tube can be a Metal-Oxide-Semiconductor Field-Effect Transistor (MOSFET). Taking the gate tube being a MOSFET as an example, a voltage is applied to the gate of the gate tube to make the gate tube in an On state, and when a voltage is applied to the source/drain of the gate tube, the gate tube can apply a voltage to the gate of the anti-fuse transistor, so that the anti-fuse transistor is in an On state. The external circuit described herein may be a circuit other than the gate tube 21, references for which can be found in FIG. 8 and the corresponding description.

In this embodiment, the memory cell is constructed by the gate tube and the anti-fuse transistor, and the anti-fuse transistor is formed by a Metal-Oxide-Semiconductor Field-Effect Transistor (MOSFET); the gate tube is electrically connected to the gate of the anti-fuse transistor; where the gate and the source of the anti-fuse transistor respectively form two ends of the first anti-fuse capacitor, and the gate and the drain of the anti-fuse transistor respectively form two ends of the second anti-fuse capacitor. Compared with the existing memory cell structure with one gate tube plus one anti-fuse capacitor, one MOSFET can directly form two anti-fuse capacitors in this embodiment, so that the memory capacity of the memory on the same integration area is greatly increased.

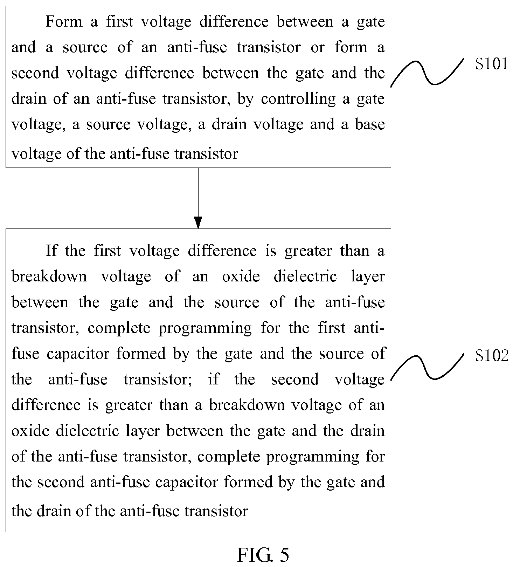

FIG. 5 is a flowchart of an operation method of a memory cell according to Embodiment 5 of the present invention. As shown in FIG. 5, the method in this embodiment can include:

S101, form a first voltage difference between the gate and the source of an anti-fuse transistor or form a second voltage difference between the gate and the drain of an anti-fuse transistor, by controlling a gate voltage, a source voltage, a drain voltage and a base voltage of the anti-fuse transistor.

The operation method of a memory cell in this embodiment can be applied to the memory cell shown in FIG. 4. Referring to FIG. 4, the gate, the source, the drain and the base of the anti-fuse transistor can be respectively connected to an external power source, and voltages applied to the gate, the source, the drain and the base of the anti-fuse transistor by the external power source are denoted as V1, V2, V3, and V4, respectively.

S102, if the first voltage difference is greater than a breakdown voltage of an oxide dielectric layer between the gate and the source of the anti-fuse transistor, complete programming for the first anti-fuse capacitor formed by the gate and the source of the anti-fuse transistor;
if the second voltage difference is greater than a breakdown voltage of an oxide dielectric layer between the gate and the drain of the anti-fuse transistor, complete programming for the second anti-fuse capacitor formed by the gate and the drain of the anti-fuse transistor.

In an optional implementation, when the anti-fuse transistor is a P-type MOSFET, the voltages V1, V3, and V4 are controlled to be a high voltage, and the voltage V2 is controlled to be a low voltage or a zero voltage, to form the first voltage difference between the gate and the source of the anti-fuse transistor. Or, V1, V2, V4 are controlled to be a high voltage, and the voltage V3 is controlled to be a low voltage or a zero voltage, to form the second voltage difference between the gate and the source of the anti-fuse transistor.

In another optional implementation, when the anti-fuse transistor is an N-type MOSFET, V1, V3, and V4 are controlled to be a low voltage, and V2 is controlled to be a high voltage or a zero voltage, to form the first voltage difference between the gate and the source of the anti-fuse transistor. Or, V1, V2, V4 are controlled to be a low voltage, and V3 is controlled to be a high voltage or a zero voltage, to form the second voltage difference between the gate and the source of the anti-fuse transistor.

In this embodiment, the specific values of the high level and the low level are not limited, and the high level and the low level are a relative amount, the purpose of which is to form a voltage difference between the gate and the source of the anti-fuse transistor. By controlling the first voltage difference to be greater than the breakdown voltage of the oxide dielectric layer between the gate and the source of the anti-fuse transistor, and by maintaining the voltage difference for a period of time, the oxide dielectric layer between the gate and the source of the anti-fuse transistor is partially broken down. After the oxide dielectric layer between the gate and the source of the anti-fuse transistor is partially broken down, a conductive path will be formed between the gate and the source of the anti-fuse transistor, thereby changing the state of the first anti-fuse capacitor formed by the gate and the source of the anti-fuse transistor, and achieving the effect of programming the first anti-fuse capacitor.

In this embodiment, the specific values of the high level and the low level are not limited, and the high level and the low level are a relative amount, the purpose of which is to form a voltage difference between the gate and the drain of the anti-fuse transistor. By controlling the second voltage difference to be greater than the breakdown voltage of the oxide dielectric layer between the gate and the drain of the anti-fuse transistor, and by maintaining the voltage difference for a period of time, the oxide dielectric layer between the gate and the drain of the anti-fuse transistor is partially broken down. After the oxide dielectric layer between the gate and the drain of the anti-fuse transistor is partially broken down, a conductive path will be formed between the gate and the drain of the anti-fuse transistor, thereby changing the state of the second anti-fuse capacitor formed by the gate and the drain of anti-fuse transistor, and achieving the effect of programming the second anti-fuse capacitor.

In this embodiment, the voltages V1, V2, V3, and V4 are respectively applied to the gate, the source, the drain, and the base of the anti-fuse transistor; by controlling the magnitude of the voltages V1, V2, V3, and V4, the first voltage difference between the gate and the source of the anti-fuse transistor is formed, or the second voltage difference between the gate and the drain of the anti-fuse transistor is formed; the first voltage difference is controlled to be greater than the breakdown voltage of the oxide dielectric layer between the gate and the source of the anti-fuse transistor, to perform a programming operation for the first anti-fuse capacitor formed by the gate and the source of the anti-fuse transistor; the second voltage difference is controlled to be larger than the breakdown voltage of the oxide dielectric layer between the gate and the drain of the anti-fuse transistor, to perform the programming for the second anti-fuse capacitance formed by the gate and the drain of the anti-fuse transistor. Compared with the existing memory cell structure with one gate tube plus one anti-fuse capacitor, one MOSFET can directly form two anti-fuse capacitors in this embodiment, so that the memory capacity of the memory on the same integration area is greatly increased. Using the method in this embodiment, programming operations can be performed on any one or two of the two anti-fuse capacitors formed by the MOSFET, and the programming mode is flexible and the efficiency is high.

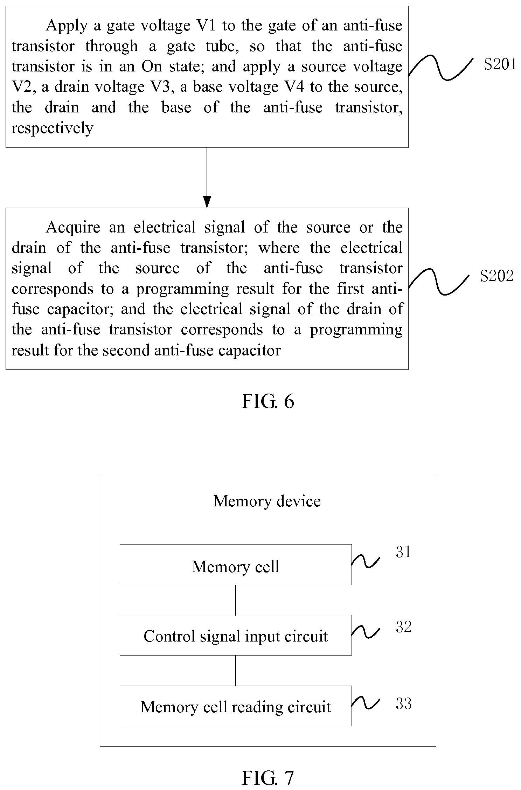

FIG. 6 is a flowchart of an operation method of a memory cell according to Embodiment 6 of the present invention. As shown in FIG. 6, the method in this embodiment can include:
S201, apply a gate voltage V1 to the gate of an anti-fuse transistor through a gate tube, so that the anti-fuse transistor is in an On state; and apply a source voltage V2, a drain voltage V3, a base voltage V4 to the source, the drain and the base of the anti-fuse transistor, respectively.

In this embodiment, the anti-fuse transistor may be a P-type MOSFET or an N-type MOSFET, for both of which V1 is controlled to be a high voltage, so that the anti-fuse transistor is in the On state.

S202, acquire an electrical signal of the source or the drain of the anti-fuse transistor; where the electrical signal of the source of the anti-fuse transistor corresponds to a programming result for the first anti-fuse capacitor; and the electrical signal of the drain of the anti-fuse transistor corresponds to a programming result for the second anti-fuse capacitor.

In an optional implementation, when the anti-fuse transistor is a P-type MOSFET, V1 is controlled to be a high voltage, V2 and V4 are controlled to be a zero voltage or the same low voltage, and no voltage is applied to V3, so as to acquire a voltage or current signal at the source of the anti-fuse transistor; where a voltage difference between V1 and V2 is much smaller than the oxide layer dielectric breakdown voltage of the anti-fuse transistor. Or, V1 is controlled to be a high voltage, V3 and V4 are controlled to be a zero voltage or the same low voltage, and no voltage is applied to V2, so as to acquire a voltage or current signal at the drain of the anti-fuse transistor; where a voltage difference between V1 and V3 is much smaller than the oxide layer dielectric breakdown voltage of the anti-fuse transistor. It should be noted that the first anti-fuse capacitor and the second anti-fuse capacitor share a power end of an external circuit, therefore, neither the writing process nor the reading process can be performed in parallel. Specifically, the operations of reading data or writing data need to be performed on the first anti-fuse capacitor and the second anti-fuse capacitor successively.

In another optional implementation, when the anti-fuse transistor is an N-type MOSFET, V1 is controlled to be a high voltage, V2 and V4 are controlled to be a zero voltage or the same low voltage, and no voltage is applied to V3, so as to acquire a voltage or current signal at the source of the anti-fuse transistor; acquire a voltage or current signal at the source of the anti-fuse transistor; where a voltage difference between V1 and V2 is much smaller than the oxide layer dielectric breakdown voltage of the anti-fuse transistor. Or, V1 is controlled to be a high voltage, V3 and V4 are controlled to be a zero voltage or the same low voltage, and no voltage is applied to V2, so as to acquire a voltage or current signal at the drain of the anti-fuse transistor; where a voltage difference between V1 and V3 is much smaller than the oxide layer dielectric breakdown voltage of the anti-fuse transistor.

In this embodiment, the voltage V1 is applied to the gate of the anti-fuse transistor through the gate tube; the voltages V2, V3, and V4 are respectively applied to the source, the drain, and the base of the anti-fuse transistor; by controlling the magnitude of the voltages V1, V2, V3 and V4, the electrical signal of the source or the drain of the anti-fuse transistor is acquired; where the electrical signal of the source of the anti-fuse transistor corresponds to the programming result for the first anti-fuse capacitor; the electrical signal of the drain of the anti-fuse transistor corresponds to the programming result for the second anti-fuse capacitor. Compared with the existing memory cell structure with one gate tube plus one anti-fuse capacitor, one MOSFET can directly form two anti-fuse capacitors in this embodiment, so that the memory capacity of the memory on the same integration area is greatly increased. The states in the two anti-fuse capacitors formed by the MOSFET can be flexibly read using the method in this embodiment, thereby conveniently acquiring the programming result for the memory cell.

FIG. 7 is a schematic structural diagram of a memory device according to Embodiment 7 of the present invention. As shown in FIG. 7, the memory device in this embodiment can include:
a memory cell 31, a control signal input circuit 32;
where the memory cell 31 can be at least one memory cell as shown in FIG. 4, and when the number of the memory cells 31 is more than one, the memory cells 31 can be configured as an array of memory cells arranged in a certain regular pattern. The control signal input circuit 32 is configured to perform the operation method of a memory cell as shown in FIG. 5.

Optionally, the memory device shown in FIG. 7 can further include: a memory cell reading circuit 33, where the memory cell reading circuit 33 is configured to perform the operation method of a memory cell as shown in FIG. 6.

The memory device of this embodiment can perform the methods shown in FIG. 5 and FIG. 6, and references for the specific implementation process and technical principles are found in the related descriptions for the methods in FIG. 5 and FIG. 6, which will not be repeated here.

Specifically, FIG. 8 is a schematic structural diagram of a memory device according to Embodiment 8 of the present invention. As shown in FIG. 8, the memory device in this embodiment can include: a memory array with 2 rows and 4 columns formed by four memory cells. Each of the memory cells includes two anti-fuse capacitors. The gate of a first anti-fuse transistor is connected to the drain of a gate tube T1, the gate of the gate tube T1 is connected to the input of a first control signal WL1, the base of the gate tube T1 is grounded, and the gate of the gate tube T1 is connected to the input of a third control signal SL1. The source of the first anti-fuse transistor is connected to a first reading end RL1, the drain of the first anti-fuse transistor is connected to a second reading end RL2, and the base of the first anti-fuse transistor is connected to a G1 end. The gate of a second anti-fuse transistor is connected to the drain of a gate tube T2, the gate of the gate tube T2 is connected to the input of the first control signal WL1, the base of the gate tube T2 is grounded, and the gate of the gate tube T2 is connected to the input of a fourth control signal SL2. The source of the second anti-fuse transistor is connected to a third reading end RL3, the drain of the second anti-fuse transistor is connected to a fourth reading end RL4, and the base of the second anti-fuse transistor is connected to the G1 end. The gate of a third anti-fuse transistor is connected to the drain of a gate tube T3, the gate of the gate tube T3 is connected to the input of a second control signal WL2, the base of the gate tube T3 is grounded, and the gate of the gate tube T3 is connected to the input of the third control signal SL1. The source of the third anti-fuse transistor is connected to the first reading end RL1, the drain of the third anti-fuse transistor is connected to the second read end RL2, and the base of the third anti-fuse transistor is connected to the G1 end. The gate of a fourth anti-fuse transistor is connected to the drain of a gate tube T4, the gate of the gate tube T4 is connected to the input of the second control signal WL2, the base of the gate tube T4 is grounded, and the gate of the gate tube T4 is connected to the input of the fourth control signal SL2. The source of the fourth anti-fuse transistor is connected to the third reading end RL3, the drain of the fourth anti-fuse transistor is connected to the fourth reading end RL4, and the base of the fourth anti-fuse transistor is connected to the G1 end. The source of a first column selection control tube BL1 forms the first reading end RL1, the source of a second column selection control tube BL2 forms the second reading end RL2, the source of a third column selection control tube BL3 forms the third reading end RL3, and the source of a fourth column selection control tube BL4 forms the fourth reading end RL4. The gate of the first column selection control tube BL1, the gate of the second column selection control tube BL2, the gate of the third column selection control tube BL3, and the gate of the fourth column selection control tube BL4 are respectively connected to a first column control signal end, a second column control signal end, a third column control signal end, and a fourth column control signal end. The drain of the first column selection control tube BL1, the drain of the second column selection control tube BL2, the drain of the third column selection control tube BL3, the drain of the fourth column selection control tube BL4, the base of the first column selection control tube BL1, the base of the second column selection control tube BL2, the base of the third column selection control tube BL3, and the base of the fourth column selection control tube BL4 are all grounded.

As shown in FIG. 8, the first control signal WL1 is used to control the On-Off of the first gate tube T1 and the second gate tube T2. When the first gate tube T1 and the second gate tube T2 are in an On state, the third control signal SL1 can apply voltages to the gates of TR1 and TR2 through the first gate tube T1; or the third control signal SL1 applies voltages to the gates of TR5 and TR6 through the gate tube T3. The second control signal WL2 is used to control the On-Off of the third gate tube T3 and the fourth gate tube T4. When the third gate tube T3 and the fourth gate tube T4 are in an On state, the fourth control signal SL2 can apply voltages to the gates of TR3 and TR4 through the second gate tube T2; or the fourth control signal SL2 applies voltages to the gates of TR7 and TR8 through the fourth gate tube T4. A base control signal G1 is used to supply voltages to the bases of the anti-fuse transistors. BL1, BL2, BL3, and BL4 are respectively column selection control tubes (MOS transistors can be used) of an array structure, and RL1, RL2, RL3, and RL4 are reading ends of the columns, respectively.

Specifically, the storing process of the anti-fuse capacitor TR1 is taken as an example, and the operation methods of other anti-fuse capacitors are similar, which will not be repeated. When the array structure of the memory cells is not programmed, the oxide dielectric layers of all of the anti-fuse transistors stay intact and are not broken down. When programming, first, a voltage is applied to the first gate tube T1 through the first control signal WL1 and the third control signal SL1, so that the first gate tube T1 is turned on (if the first gate tube T1 is an NMOS device, a certain positive voltage is provided to the first control signal WL1 such that the first gate tube T1 is turned on, meanwhile the third control signal SL1 provides a high voltage, and this high voltage is used as a programming voltage of the anti-fuse capacitor TR1); then the control tube BL1 is turned on to provide a current path for programming for the anti-fuse capacitor TR1, meanwhile making the voltages of the base control signal G1 and the third control signal SL1 are same or similar, thereby improving programming rate. This voltage state is maintained for a certain period of time such that the oxide dielectric layer of the anti-fuse capacitor TR1 is broken down, thereby achieving programming for the anti-fuse capacitor TR1.

Specifically, the reading process of the anti-fuse capacitor TR1 is taken as an example, and the operation methods of other anti-fuse capacitors are similar, which will not be repeated. First, a voltage is applied to the first gate tube T1 through the first control signal WL1 and the third control signal SL1, so that the first gate tube T1 is turned on. (If the first gate tube T1 is an NMOS device, the voltage of the first control signal WL1 may be the same as or different from the one for programming, the purpose of which is to provide a certain positive voltage so that the first gate tube T1 is turned on; meanwhile the third control signal SL1 is controlled to be a positive voltage smaller than the programming voltage, and this positive voltage is to read the breakdown or un-breakdown state of the anti-fuse capacitor TR1, so it is much smaller than the breakdown voltage so that it does not affect the state of TR1.) Let the G1 end be grounded, then the control tube BL1 is turned on, providing a current path for programming for the anti-fuse capacitor TR1, and the state of the anti-fuse capacitor TR1 is read at the reading end RL1. (If the anti-fuse capacitor TR1 has been programmed, a high level can be read at RL1, and if the anti-fuse capacitor TR1 is not programmed, a low level is read at RL1).

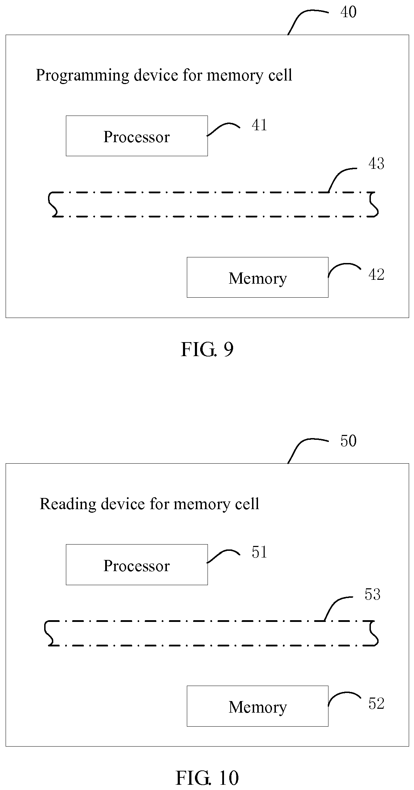

FIG. 9 is a schematic structural diagram of a programming device for a memory cell according to Embodiment 9 of the present invention. As shown in FIG. 9, the programming device 40 for the memory cell in this embodiment can include: a processor 41 and a memory 42;
the memory 42 is configured to store a program; and
the processor 41 is configured to execute the program stored in the memory 42, when the program is executed, the processor 41 is configured to program the memory cell of FIG. 4 using the operation method of a memory cell of FIG. 5.

Optionally, the memory 42 can be either independent or integrated with the processor 41.

When the memory 42 is a device independent from the processor 41, the programming device 40 for the memory cell can further include: a bus 43 for connecting the memory 42 and the processor 41.

FIG. 10 is a schematic structural diagram of a reading device for a memory cell according to Embodiment 10 of the present invention. As shown in FIG. 10, the reading device 50 for the memory cell in this embodiment can include: a processor 51 and a memory 52;
the memory 52 is configured to store a program; and
the processor 51 is configured to execute the program stored in the memory 52, when the program is executed, the processor 51 is configured to read a programming result for the memory cell of FIG. 4 using the operation method of a memory cell of FIG. 6.

Optionally, the memory 52 can be either independent or integrated with the processor 51.

When the memory 52 is a device dependent from the processor 51, the reading device 50 for the memory cell can further include: a bus 53 for connecting the memory 52 and the processor 51.

An embodiment of the present invention further provides a computer readable memory medium, including: instructions, which when executed on a computer, cause the computer to execute the operation method of a memory cell of FIG. 5 to program the memory cell of FIG. 4.

An embodiment of the present invention further provides a computer readable memory medium, including: instructions, which when executed on a computer, cause the computer to execute the operation method of a memory cell of FIG. 6 to read a programming result for the memory cell of FIG. 4.

The computer readable medium includes a computer memory medium and a communication medium, where the communication medium includes any medium that is convenient for transferring the computer program from one location to another. A memory medium may be any available media that can be accessed by a general purpose or special purpose computer. An exemplary memory medium is coupled to the processor to enable the processor to read information from the memory medium, and write information to the memory medium. Of course, the memory medium can also be a part of the processor. The processor and the memory medium may be located in an application specific integrated circuit (ASIC). Additionally, the application specific integrated circuit may be located in the user equipment. Of course, the processor and the memory medium may also exist in a communication device as discrete components.

After considering the specification and practicing the inventions disclosed herein, it will be easy for those skilled in the art to think of other implementations of the present disclosure. The present invention is intended to cover any variations, uses, or adaptations of the present disclosure, which are in accordance with the general principles of the present disclosure and include common knowledge or conventional technical means in the art that are not disclosed in the present disclosure. The specification and embodiments are regarded as illustrative only, the true scope and spirit of the present disclosure are pointed out by the following claims.

It should be understood that the present disclosure is not limited to the precise structures described above and shown in the accompanying drawings, and various modifications and changes can be made without departing from the scope thereof. The scope of the present disclosure is to be limited only by the appended claims.

## Claims

1. A memory cell, comprising:
an anti-fuse transistor, comprising a gate, a source and a drain, the anti-fuse transistor being formed by a Metal-Oxide-Semiconductor Field-Effect Transistor (MOSFET); and
a gate tube, electrically connected to the gate of the anti-fuse transistor, wherein the gate and the source respectively form two ends of a first anti-fuse capacitor, and the gate and the drain respectively form two ends of a second anti-fuse capacitor.

2. The memory cell according to claim 1, wherein the two ends of the first anti-fuse capacitor are respectively connected to a power end of an external circuit;
wherein a voltage is applied to the two ends of the first anti-fuse capacitor through the power end of the external circuit to partially break down an oxide dielectric layer between the gate and the source of the anti-fuse transistor, so that the gate and the source of the anti-fuse transistor form a conductive path to complete programming for the first anti-fuse capacitor.

3. The memory cell according to claim 1, wherein the two ends of the second anti-fuse capacitor are respectively connected to a power end of an external circuit;
wherein a voltage is applied to the two ends of the second anti-fuse capacitor through the power end of the external circuit to partially break down an oxide dielectric layer between the gate and the drain of the anti-fuse transistor, so that the gate and the drain of the anti-fuse transistor form a conductive path to complete programming for the second anti-fuse capacitor.

4. The memory cell according to any one of claims 1 to 3, wherein the gate tube comprises a Metal-Oxide-Semiconductor Field-Effect Transistor (MOSFET).

5. An operation method of a memory cell, applied to the memory cell according to any one of claims 1 to 4, the method comprising:
forming a first voltage difference between the gate and the source of the anti-fuse transistor or forming a second voltage difference between the gate and the drain of the anti-fuse transistor, by controlling magnitude of a gate voltage, a source voltage, a drain voltage and a base voltage of the anti-fuse transistor;
if the first voltage difference is greater than a breakdown voltage of an oxide dielectric layer between the gate and the source of the anti-fuse transistor, completing a programming operation for the first anti-fuse capacitor formed by the gate and the source of the anti-fuse transistor; and
if the second voltage difference is greater than a breakdown voltage of an oxidized dielectric layer between the gate and the drain of the anti-fuse transistor, completing programming for the second anti-fuse capacitor formed by the gate and the drain of the anti-fuse transistor.

6. The method according to claim 5, wherein when the anti-fuse transistor is a P-type MOSFET, the forming a first voltage difference between the gate and the source of the anti-fuse transistor by controlling magnitude of a gate voltage, a source voltage, a drain voltage and a base voltage of the anti-fuse transistor comprises:
controlling the gate voltage, the drain voltage and the base voltage of the anti-fuse transistor to be a high voltage, and controlling the source voltage of the anti-fuse transistor to be a low voltage or a zero voltage, to form the first voltage difference between the gate and the source of the anti-fuse transistor.

7. The method according to claim 5, wherein when the anti-fuse transistor is a P-type MOSFET, the forming a second voltage difference between the gate and the drain of the anti-fuse transistor by controlling magnitude of a gate voltage, a source voltage, a drain voltage and a base voltage of the anti-fuse transistor comprises:
controlling the gate voltage, the source voltage and the base voltage of the anti-fuse transistor to be a high voltage, and controlling the drain voltage of the anti-fuse transistor to be a low voltage or a zero voltage, to form the second voltage difference between the gate and the source of the anti-fuse transistor.

8. The method according to claim 5, wherein when the anti-fuse transistor is an N-type MOSFET, the forming a first voltage difference between the gate and the source of the anti-fuse transistor by controlling magnitude of a gate voltage, a source voltage, a drain voltage and a base voltage of the anti-fuse transistor comprises:
controlling the gate voltage, the drain voltage and the base voltage of the anti-fuse transistor to be a low voltage, and controlling the source voltage of the anti-fuse transistor to be a high voltage or a zero voltage, to form the first voltage difference between the gate and the source of the anti-fuse transistor.

9. The method according to claim 5, wherein when the anti-fuse transistor is an N-type MOSFET, the forming a second voltage difference between the gate and the drain of the anti-fuse transistor by controlling magnitude of a gate voltage, a source voltage, a drain voltage and a base voltage of the anti-fuse transistor comprises:
controlling the gate voltage, the source voltage and the base voltage of the anti-fuse transistor to be a low voltage, and controlling the drain voltage of the anti-fuse transistor to be a high voltage or a zero voltage, to form the second voltage difference between the gate and the source of the anti-fuse transistor.

10. An operation method of a memory cell, applied to the memory cell according to any one of claims 1 to 4, the method comprising:
applying a gate voltage to the gate of the anti-fuse transistor through the gate tube, so that the anti-fuse transistor is in an On state; applying a source voltage, a drain voltage, a base voltage to the source, the drain and a base of the anti-fuse transistor, respectively; and
acquiring an electrical signal of the source or the drain of the anti-fuse transistor; wherein the electrical signal of the source of the anti-fuse transistor corresponds to a programming result for the first anti-fuse capacitor; and the electrical signal of the drain of the anti-fuse transistor corresponds to a programming result for the second anti-fuse capacitor.

11. The method according to claim 10, wherein when the anti-fuse transistor is a P-type MOSFET, the acquiring an electrical signal of the source of the anti-fuse transistor comprises:
controlling the gate voltage of the anti-fuse transistor to be a high voltage, the source voltage and the base voltage of the anti-fuse transistor to be a zero voltage or a same low voltage, and not applying a voltage to the drain of the anti-fuse transistor; acquiring a voltage or current signal at the source of the anti-fuse transistor; wherein a voltage difference between the gate and the source of the anti-fuse transistor is much smaller than the oxide layer dielectric breakdown voltage of the anti-fuse transistor;
when the anti-fuse transistor is the P-type MOSFET, the acquiring an electrical signal of the drain of the anti-fuse transistor comprises:
controlling the gate voltage of the anti-fuse transistor to be a high voltage, the drain voltage and the base voltage of the anti-fuse transistor to be a zero voltage or a same low voltage, and not applying a voltage to the source of the anti-fuse transistor; acquiring a voltage or current signal at the drain of the anti-fuse transistor; wherein a voltage difference between the gate and the drain of the anti-fuse transistor is much smaller than the oxide layer dielectric breakdown voltage of the anti-fuse transistor.

12. The method according to claim 10, wherein when the anti-fuse transistor is an N-type MOSFET, the acquiring an electrical signal of the source of the anti-fuse transistor comprises:
controlling the gate voltage of the anti-fuse transistor to be a high voltage, the source voltage and the base voltage of the anti-fuse transistor to be a zero voltage or a same low voltage, and not applying a voltage to the drain of the anti-fuse transistor; acquiring a voltage or current signal at the source of the anti-fuse transistor; acquiring a voltage or current signal at the source of the anti-fuse transistor; wherein a voltage difference between the gate and the source of the anti-fuse transistor is much smaller than an oxide layer dielectric breakdown voltage of the anti-fuse transistor;
when the anti-fuse transistor is the N-type MOSFET, the acquiring an electrical signal of the drain of the anti-fuse transistor comprises:
controlling the gate voltage of the anti-fuse transistor to be a high voltage, the drain voltage and the base voltage of the anti-fuse transistor to be a zero voltage or a same low voltage, and not applying a voltage to the source of the anti-fuse transistor; acquiring a voltage or current signal at the drain of the anti-fuse transistor; wherein a voltage difference between the gate and the drain of the anti-fuse transistor is much smaller than the oxide layer dielectric breakdown voltage of the anti-fuse transistor.

13. A memory device, comprising: at least one memory cell according to any one of claims 1 to 4, a control signal input circuit; wherein the control signal input circuit is configured to generate a gate voltage, a source voltage, a drain voltage and a base voltage of the anti-fuse transistor, to execute the operation method of a memory cell according to any one of claims 5 to 9 on the memory cell.

14. The memory device according to claim 13, further comprising: a memory cell reading circuit, wherein the memory cell reading circuit is configured to execute the operation method of a memory cell according to any one of claims 10 to 12 on the memory cell.

15. A programming device for a memory cell, comprising:
a memory, configured to store a program; and
a processor, configured to execute the program stored in the memory, wherein when the program is executed, the processor is configured to program the memory cell according to any one of claims 1 to 4 using the operation method of a memory cell according to any one of claims 5 to 9.

16. A reading device for a memory cell, comprising:
a memory, configured to store a program; and
a processor, configured to execute the program stored in the memory, wherein when the program is executed, the processor is configured to read a programming result for the memory cell according to any one of claims 1 to 4 using the operation method of a memory cell according to any one of claims 10 to 12.

17. A computer readable memory medium, comprising: instructions, which when executed on a computer, cause the computer to execute the operation method of a memory cell according to any one of claims 5 to 9 to program the memory cell according to any one of claims 1 to 4.

18. A computer readable memory medium, comprising: instructions, which when executed on a computer, cause the computer to execute the operation method of a memory cell according to any one of claims 10 to 12 to read a programming result for the memory cell according to any one of claims 1 to 4.
